# EUROPEAN PATENT SPECIFICATION

(11) **EP 1 993 181 B1**
(45) Date of publication and mention of the grant of the patent: **31.07.2013**
(21) Application number: 08156064.1
(22) Date of filing: 13.05.2008
(51) Int. Cl.: H02H 1/00

(54) **Arc detector**
Lichtbogendetektor
Détecteur d'arc électrique

(30) Priority: 14.05.2007 US 747970
(43) Date of publication of application: 19.11.2008
(73) Proprietor: GENERAL ELECTRIC COMPANY, Schenectady, NY 12345 (US)
(72) Inventor: Rao, Ravinuthala Ramakrishna, Chennasandra 560067, Bangalore Karnataka (IN); Rapol, Umakant Damodar, AECS Layout 560037, Bangalore, Karnataka (IN); Asokan, Thangavelu, AECS Layout, Kundalahalli 560037, Bangalore, Karnataka (IN); Ungarala, Satyanarayana Murthy, Manjunatha Layout 560067, Bangalore, Karnataka (IN)
(74) Representative: Picker, Madeline Margaret

(56) References cited:
- EP-A1- 0 838 687
- WO-A1-92/08143
- WO-A1-2005/088802
- US-A- 5 578 931

## Description

Embodiments of the present invention are generally related to electrical arc detection, and, more particularly, to a radio frequency (RF) arc identification system for electrical distribution equipment.

Detection of arc flashes indicative of an arcing event is critical as a first step in mitigating undesirable and/or dangerous arcing conditions in electrical equipment, such as electrical distribution equipment. One known technique for detecting arcing events is to use optical detectors to sense the arc flash associated with an arcing event. However, such detectors are usually limited to line of sight detection and must be positioned relatively close to a potential source of an arc. Another technique is to use current monitors to evaluate current perturbations in a conductor indicative of an arcing event. However, this technique may require onerous processing demands resulting in an undesirably long reaction time for identifying an arcing event. Improved arc detection is desired to provide quick and effective mitigation of arcing conditions.

US-A-5 578 931 which forms the preamble of claim 1, concerns a method and apparatus for detecting an arcing fault on a power line carrying a load current. A load signal parameter indicative of power flowing through the power line is monitored, and a frequency spectrum of sample frequency components is derived based on the load signal parameter. Individual components of the spectrum of sample frequency components are compared to corresponding frequency values of an arcing fault signal model to determine whether an arcing fault exists on the power line.

EP-A-0 838 687 concerns a fault sensor device comprising a receiver for receiving microwaves radiated from a monitored object. A detector connected to the receiver converts and outputs the microwaves into a video signal, and a signal processor converts the video signal output into a presentation signal. A fault is determined based on one of the duration and the frequency of, and the level of, the video signal, and an alarm signal is issued.

The present invention provides a system for identifying an arcing event in electrical distribution equipment as defined in appended claim 1. In an example embodiment, the system includes memory for storing an arcing radio frequency characteristic indicative of an arcing event generated in electrical distribution equipment and a noise radio frequency characteristic indicative of background electrical noise. The system also includes a sensor for detecting radio frequency signals resulting from the arcing event and propagating wirelessly from the electrical distribution equipment. The system also includes a processor for processing the radio frequency signals detected by the sensor to extract radio frequency characteristics from the detected signals and including a comparator for comparing the extracted frequency characteristics to the arcing radio frequency characteristic and the noise radio frequency characteristic stored in memory to identify occurrence of an arcing event. The system further includes an arc alarm generator for generating an arc fault signal indicative of the occurrence of the arcing event.

In another example embodiment, the invention includes a method for identifying an arcing event in electrical distribution equipment. The method includes detecting radio frequency signals resulting from the arcing event generated by electrical distribution equipment and propagating wirelessly from the electrical distribution equipment. The method also includes extracting radio frequency characteristics from the detected signals and comparing the extracted radio frequency characteristics to a predetermined arcing radio frequency characteristic and a predetermined noise radio frequency characteristic to identify an arcing event occurrence of an arcing event. The method further includes generating an arc fault signal indicative of the occurrence of the arcing event.

Various features, aspects, and advantages of the present invention will become better understood when the following detailed description is read with reference to the accompanying drawings in which like characters represent like parts throughout the drawings, wherein:
FIG. 1A is a graph of example frequency response characteristics indicative of an unconfined arcing event in electrical distribution equipment;
FIG. 1B is a graph of example frequency response characteristics indicative of a confined arcing event in electrical distribution equipment;
FIG. 2 is a schematic diagram illustrating an example embodiment of a system for identifying an arcing event in electrical distribution equipment;
FIG. 3 is an example electrical distribution equipment environment in which the system of FIG. 2 may be used; and
FIG. 4 is a flow diagram for an exemplary embodiment of a method for identifying an arcing event in accordance with aspects of the present invention.

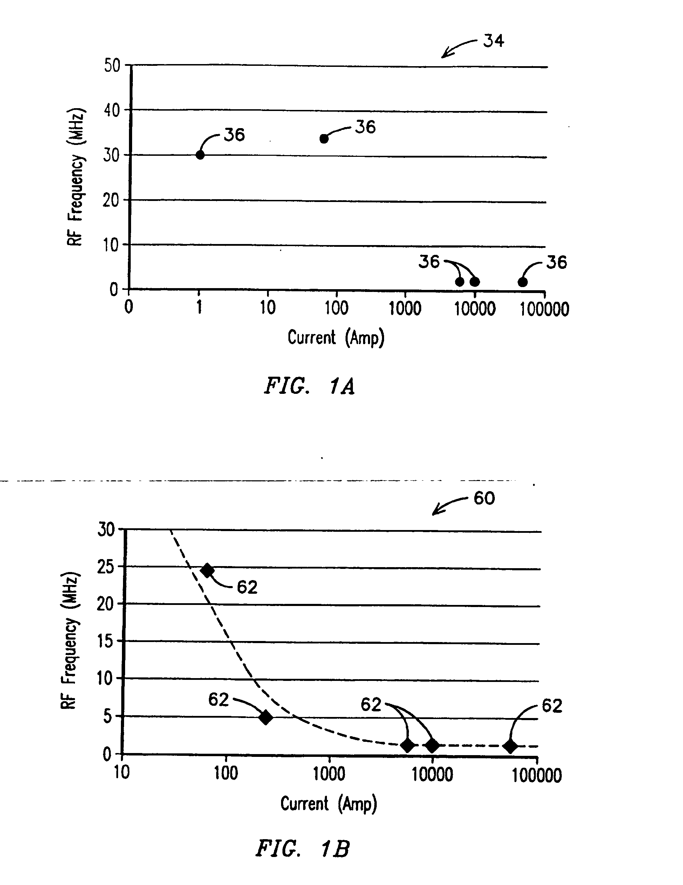

The inventors of the present invention have realized that an arcing event in electrical distribution equipment emits RF energy in certain frequency bands and/or at certain frequency magnitudes different from other RF sources, depending, for example, on a current magnitude associated with the arcing event. FIG. 1A is a graph 34 of example frequency response characteristics indicative of unconfined, or non-enclosed arcing events in electrical distribution equipment. For example, such unconfined arcing events may occur in bus bars and/or phase conductors that are typically exposed to an ambient environment. The graph 34 represents frequency response data derived using an RF sensor to wirelessly detect RF energy resulting from experimentally induced arc flashes, or arcing events. The graph 34 shows RF frequency response characteristics in the form of peak frequency response values 36 derived using Fourier transform techniques and corresponding to different current levels responsive to the experimentally induced arcing events. As can be seen in the graph 34, at currents less than about 100 amps, arcing events exhibit peak RF frequency responses in the range of about 20 MHz to about 30 MHz, and may exhibit peak RF frequency responses in the range of about 10 MHz to about 50 MHz. At currents greater than about 100 amps, arcing events exhibit peak RF frequency responses in the range of about 1 MHz to about 2 MHz and may exhibit peak RF frequency responses in the range of about 1 MHz to about 5MHz.

FIG. 1B is a graph 60 of example frequency response characteristics indicative of confined, or enclosed, arcing events in electrical distribution equipment. For example, such confined arcing events may occur in switchgear, terminal boxes, and/or motor control units/boxes that are typically enclosed. The graph 60 represents frequency response data derived using an RF sensor to wirelessly detect RF energy resulting from experimentally induced arcing events. The graph 60 shows RF frequency response characteristics in the form of peak frequency response values 62 derived using Fourier transform techniques and corresponding to different current levels responsive to the experimentally induced arcing events. As can be seen in the graph 60 the arcing events tend to exhibit peak RF frequency responses that exponentially decrease with increasing current. For example, in a current range of about 100 amps, the peak RF frequency responses typically occur around 25 MHz. In a current range of about 300 amps, the peak RF frequency responses typically occur around 5 MHz, while above a current of about 8000 amps, the peak RF frequency responses typically occur around 2 MHz.

Using such experimentally derived data, the inventors have determined that arcing events in electrical distribution equipment exhibit certain frequency characteristics different from other RF noise, and have innovatively realized that such characteristics may be used to identify such arcing events. In addition to peak frequency response characteristics, the inventors have also experimentally determined that arcing events may exhibit different peak frequency response amplitudes compared to other RF noise generating events, even when the respective peak frequencies occur at the same frequency. Furthermore, the inventors have determined that arcing events in electrical distribution equipment exhibit certain frequency characteristics corresponding to a current associated with arc, and whether the arc is confined or unconfined. By innovatively discriminating frequency characteristics of RF energy generated by an arcing event from frequency characteristics of RF noise energy normally produced by electrical equipment, and/or identifying arcing frequency characteristics based on an predetermined frequency characteristics present at a certain current levels, an arcing condition may be quickly identified, thereby allowing remedial action to be taken more quickly for mitigating the arcing condition.

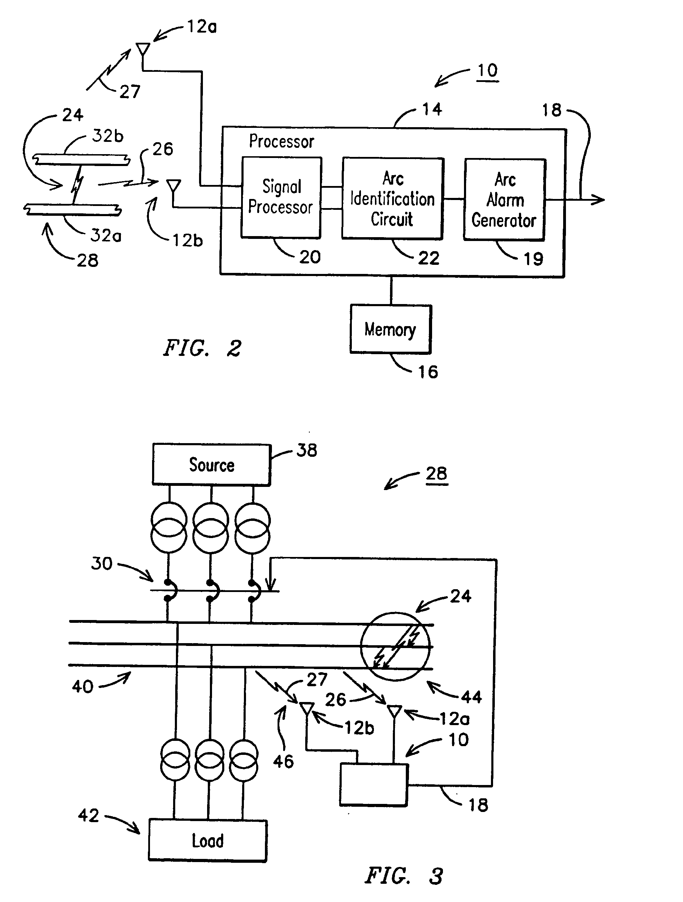

FIG. 2 is a schematic diagram illustrating an example embodiment of a system 10 for identifying an arcing event in electrical distribution equipment, such as the example electrical distribution equipment 28 depicted in FIG. 3. The system 10 may be configured for sensing RF signals 26 indicative of an arcing event, such as RF signal wirelessly emitted by an arc 24 generated between conductors 32a, 32b. The system 10 may also be configured for sensing RF signals 27 indicative of background noise, such as RF signals normally emitted by electrical distribution equipment, and identifying an arcing event. Based on these signals 26, 27, the system 10 may identify an arcing condition.

In an example embodiment, the system 10 may include a memory 16 for storing at least one arcing radio frequency characteristic indicative of an arcing event generated in electrical distribution equipment and at least one noise radio frequency characteristic indicative of background electrical noise. The system 10 may also include one or more sensors 12a, 12b, such as respective RF antennas, for detecting radio frequency signals 26, 27 resulting from the arcing event and/or background noise propagating wirelessly from the electrical distribution equipment. Although two sensors 12a, 12b are depicting in FIG. 2, it should be understood that one sensor or more than one sensor may be used to perform the same function. The system 10 may include a processor 14 for processing the radio frequency signals 26, 27 detected by the sensor(s) 12a, 12b to extract radio frequency characteristics from the detected signals. The processor 14 may further include an arc identification circuit 22, such as a comparator for comparing the extracted frequency characteristics to the arcing radio frequency characteristic and/or the noise radio frequency characteristic stored in memory 16 to identify occurrence of an arcing event. The system 10 may further include an arc alarm generator 19 for generating an arc fault signal 18 indicative of the occurrence of the arcing event. The arc fault signal 18 may be used to control an operation of the electrical distribution equipment 28. For example, the arc fault signal 18 may be used to open a circuit breaker 30 to disconnect an electrical power source 38 from an electrical load 42 responsive to an arc 24 occurring relative to a bus bar 40.

The RF characteristic stored in memory 16 and used for identifying an arcing condition may include a predetermined peak frequency response and/or a predetermined peak frequency response amplitude. The arcing radio frequency characteristic may include a peak frequency response different than a peak frequency response of the noise radio frequency characteristic. Accordingly, an RF characteristic sensed by the system 10 may be compared to the different characteristics stored in memory 16 to determine if the sensed RF characteristic matches one of the stored characteristics, thereby allowing a relatively quick determination of whether the sensed characteristic is indicative of an arc or normal RF background noise.

In another example embodiment of the invention, the arcing radio frequency characteristic may include a peak frequency response amplitude different than a peak frequency response amplitude of the noise radio frequency characteristic. In another embodiment, the arcing radio frequency characteristic may be selected according to a current level present in the electrical equipment. For example, for an electrical current of less than about 1 kilo-volt-ampere present in equipment being monitored, an arcing radio frequency characteristic used to identify an arcing condition may include a peak frequency response ranging from about 30 megahertz to about 40 megahertz. In another embodiment, for an electrical current of more than about 1 kilo-volt-ampere, an arcing radio frequency characteristic used to identify an arcing condition may include a peak frequency response of about 1 megahertz to about 2 megahertz. By recognizing that the arc characteristics vary with the current level in the electrical distribution equipment, a smaller range of frequencies may be more efficiently monitored compared to needing to monitor a larger frequency range. In yet another embodiment, the arcing radio frequency characteristic may include peak frequency response amplitude greater than a noise peak frequency response amplitude by about a factor of 10.

In another example embodiment of the invention, the sensors 12a, 12b may include a first antenna and a second antenna. The first antenna may be configured for detecting radio frequency signals having the arcing radio frequency characteristic, such as by being tuned to detect RF energy in a frequency range corresponding to the frequency characteristic generated by the arcing event. As shown in FIG. 3, the first antenna may be disposed proximate a region 44 of the electrical distribution equipment 28 likely to experience arcing. For example, the first antenna may be disposed in the range of about 1 foot to about 30 feet from the electrical distribution equipment. The first antenna may be configured as a directional antenna that may be aimed at the region 44 likely to experience arcing so as to be focused for receiving RF energy indicative of arcing. The second antenna may be configured for detecting radio frequency signals having the noise radio frequency characteristic, such as by being tuned to detect RF energy in a frequency range corresponding to the frequency characteristic generated by background noise. As shown in FIG. 3, the second antenna may be disposed proximate a region 44 of the electrical distribution equipment 28 likely to be a source of background noise. For example, the second antenna may be disposed in the range of about 1 foot to about 30 feet from the electrical distribution equipment. The second antenna may be configured as a directional antenna that may be aimed at the region 46 likely to generate RF background noise so as to be focused for receiving RF energy indicative of the noise.

In another example embodiment, the system 10 may be configured for discriminating between an emitted RF signal indicative of an arcing event and emitted RF signals indicative of background noise. As shown in FIG. 2, the system 10 may include a first sensor 12a disposed proximate electrical distribution equipment for sensing a first radio frequency signal 26 likely to include an arcing radio frequency characteristic and a second sensor 12b disposed proximate the electrical distribution equipment for sensing a second radio frequency signal 27 likely to include a noise radio frequency characteristic. The system 10 may include a signal processor 20 for processing the first radio frequency signal 26 and the second radio frequency signal 27 detected by the respective sensors 12a, 12b to extract the arcing radio frequency characteristic and the noise radio frequency characteristic from the signals 26, 27. For example, the signal processor 20 may be configured for performing a Fourier transform to extract the frequency characteristics from the signals 26, 27. In another example embodiment, the signal processor 20 may include a filter for extracting frequency characteristics in desired frequency ranges, such as frequency ranges likely to include arcing radio frequency characteristics and/or noise radio frequency characteristics. The system 10 may also include an arc identification circuit 22 in the form of a discriminator for discriminating the arcing radio frequency characteristic from the noise radio frequency characteristic to identify occurrence of an arcing event. The system 10 may further include an arc alarm generator 19 for generating an arc fault signal 18 indicative of the occurrence of an arcing event. The arc fault signal 18 may be used to control an operation of the electrical distribution equipment 28 as shown in FIG. 3.

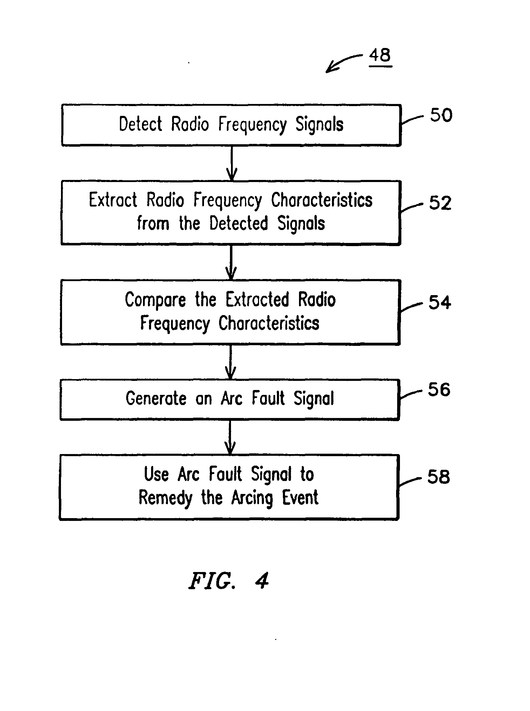

FIG. 4 is a flow diagram 48 for an exemplary embodiment of a method for identifying arcing conditions in accordance with aspects of the present invention. The method for identifying an arcing event in electrical distribution equipment may include detecting radio frequency signals 50 resulting from the arcing event generated by electrical distribution equipment and propagating wirelessly from the electrical distribution equipment. The method may then include extracting radio frequency characteristics from the detected signals 52 and comparing the extracted radio frequency characteristics 54 to a predetermined arcing radio frequency characteristic and a predetermined noise radio frequency characteristic to identify an arcing event occurrence of an arcing event. The predetermined radio frequency characteristics may include peak frequency responses and/or peak frequency response amplitudes indicative of an arcing event and background noise. The predetermined arcing radio frequency characteristics may be related to a current present in the electrical equipment. The method may then include generating an arc fault signal 56 indicative of the occurrence of the arcing event. The arc fault signal may then be used to remedy the arcing event 58. In another example embodiment, the method may include relating the predetermined arcing radio frequency characteristic to a current present in the electrical equipment so as to adapt the method for detecting arcing event corresponding to the current present in the electrical equipment.

While certain embodiments of the present invention have been shown and described herein, such embodiments are provided by way of example only. Numerous variations, changes and substitutions will occur to those of skill in the art without departing from the invention herein. Accordingly, it is intended that the invention be limited only by the scope of the appended claims.

## Claims

1. A system (10) for identifying an arcing event (58) in electrical distribution equipment (28), comprising
a first sensor (12a) disposed proximate electrical distribution equipment (28) for sensing a first radio frequency signal (26) likely to include an arcing radio frequency characteristic indicative of an arcing event (58) generated in the electrical distribution equipment (28); and
**characterised in that** the system (10) comprising
a second sensor (12b) disposed proximate the electrical distribution equipment (28) for sensing a second radio frequency signal (27) likely to include a noise radio frequency characteristic indicative of background electrical noise generated by the electrical distribution equipment (28);
a signal processor (20) for processing the first radio frequency signal (26) and the second radio frequency signal (27) detected by the respective sensors (12a and 12b) to extract the arcing radio frequency characteristic and the noise radio frequency characteristic from the signals (26);
a discriminator for discriminating the arcing radio frequency characteristic from the noise radio frequency characteristic to identify occurrence of an arcing event (58); and
an arc alarm generator (19) for generating an arc fault signal (18) indicative of the occurrence of the arcing event (58).

2. The system (10) of claim 1, further comprising:
memory (16) for storing an arcing radio frequency characteristic indicative of an arcing event (58) generated in the electrical distribution equipment (28) and a noise radio frequency characteristic indicative of background electrical noise; and
a processor (14) comprising the signal processor (20) and further including a comparator for comparing the extracted frequency characteristics to the arcing radio frequency characteristic and the noise radio frequency characteristic stored in memory (16) to identify occurrence of an arcing event (58).

3. The system (10) of claim 1 or claim 2, wherein the arcing radio frequency characteristic comprises a peak frequency response different than a peak frequency response of the noise radio frequency characteristic.

4. The system (10) of any preceding claim, wherein the arcing radio frequency characteristic comprises a peak frequency response amplitude different than a peak frequency response amplitude of the noise radio frequency characteristics.

5. The system (10) of any preceding claim, wherein the arcing radio frequency characteristic is identified according to a current level present in the electrical equipment.

6. The system (10) of any preceding claim, wherein the arcing radio frequency characteristic comprises a peak frequency response of about 10 megahertz to about 50 megahertz for a current less than about 1 kilo-volt-ampere.

7. The system (10) of any preceding claim, wherein the arcing radio frequency characteristic comprises a peak frequency response of about 1 megahertz to about 5 megahertz for a current more than about 1 kilo-volt-ampere.

8. The system (10) of any preceding claim, wherein the arcing radio frequency characteristic comprises a peak frequency response amplitude greater than a noise frequency response amplitude responsive to a distance of the first sensor (12a) from a source of the arcing event (58).

9. The system (10) of any preceding claim, wherein the first sensor (12a) comprises a first antenna configured for detecting radio frequency signals (26) having the arcing radio frequency characteristic.

10. The system (10) of any preceding claim, wherein the second sensor (12b) comprises a second antenna configured for detecting radio frequency signals (26) having the noise radio frequency characteristic.

## Patentansprüche

1. System (10) zum Identifizieren eines Lichtbogenereignisses (58) in einer elektrischen Verteilungsanlage (28), aufweisend:
einen ersten Sensor (12a), der in unmittelbarer Nähe der elektrischen Verteilungsanlage (28) angeordnet ist, um ein erstes Funkfrequenzsignal (26) zu erfassen, das wahrscheinlich eine Lichtbogenfunkfrequenzkennlinie enthält, die ein in der elektrischen Verteilungsanlage (28) erzeugtes Lichtbogenereignis (58) erkennen lässt; und
**dadurch gekennzeichnet, dass** das System (10) aufweist:
einen zweiten Sensor (12b), der in unmittelbarer Nähe der elektrischen Verteilungsanlage (28) angeordnet ist, um ein zweites Funkfrequenzsignal (27) zu erfassen, das wahrscheinlich eine Störungsfunkfrequenzkennlinie enthält, die eine von der elektrischen Verteilungsanlage (28) erzeugte elektrische Hintergrundstörung erkennen lässt;
einen Signalprozessor (20) zum Verarbeiten des von den entsprechenden Sensoren (12a) und (12b) detektierten ersten Funkfrequenzsignals (26) und zweiten Funkfrequenzsignals (27), um die Lichtbogenfunkfrequenzkennlinie und die Störungsfunkfrequenzkennlinie aus den Signalen (26) zu entziehen;
eine Unterscheidungseinrichtung zum Unterscheiden der Lichtbogenfunkfrequenzkennlinie von der Störungsfunkfrequenzkennlinie, um das Auftreten eines Lichtbogenereignisses (58) zu identifizieren; und
einen Lichtbogenalarmgenerator (19) zum Erzeugen eines Lichtbogenfehlersignals (18), das das Auftreten eines Lichtbogenereignisses (58) erkennen lässt.

2. System (10) nach Anspruch 1, ferner aufweisend:
einen Speicher (16) zum Speichern einer Lichtbogenfunkfrequenzkennlinie, die ein in der elektrischen Anlage (28) erzeugtes Lichtbogenereignis (58) erkennen lässt, und einer Störungsfrequenzkennlinie, die eine elektrische Hintergrundstörung erkennen lässt; und
einen Prozessor (14), der den Signalprozessor (20) aufweist, und ferner einen Komparator zum Vergleichen der entnommenen Frequenzkennlinien mit der im Speicher (16) gespeicherten Lichtbogenfunkfrequenzkennlinie und Störungsfunkfrequenzkennlinie aufweist, um das Auftreten eines Lichtbogenereignisses (58) zu identifizieren.

3. System (10) nach Anspruch 1 oder Anspruch 2, wobei die Lichtbogenfunkfrequenzkennlinie einen Spitzenfrequenzgang aufweist, der sich von einem Spitzenfrequenzgang der Störungsfunkfrequenzkennlinie unterscheidet.

4. System (10) nach einem der vorstehenden Ansprüche, wobei die Lichtbogenfunkfrequenzkennlinie eine Spitzenfrequenzgangamplitude aufweist, die sich von einer Spitzenfrequenzgangamplitude der Störungsfunkfrequenzkennlinien unterscheidet.

5. System (10) nach einem der vorstehenden Ansprüche, wobei die Lichtbogenfunkfrequenzkennlinie gemäß einem in der elektrischen Anlage vorliegenden Strompegel identifiziert wird.

6. System (10) nach einem der vorstehenden Ansprüche, wobei die Lichtbogenfunkfrequenzkennlinie einen Spitzenfrequenzgang von ca. 10 Megahertz bis ca. 50 Megahertz für einen Strom von weniger als ca. 1 Kilo-Volt-Ampere aufweist.

7. System (10) nach einem der vorstehenden Ansprüche, wobei die Lichtbogenfunkfrequenzkennlinie einen Spitzenfrequenzgang von ca. 1 Megahertz bis ca. 5 Megahertz für einen Strom von mehr als ca. 1 Kilo-Volt-Ampere aufweist.

8. System (10) nach einem der vorstehenden Ansprüche, wobei die Lichtbogenfunkfrequenzkennlinie eine Spitzenfrequenzgangamplitude aufweist, die größer als eine Störungsfunkfrequenzgangamplitude in Reaktion auf einen Abstand des ersten Sensors (12a) von einer Quelle des Lichtbogenereignisses (58) ist.

9. System (10) nach einem der vorstehenden Ansprüche, wobei der erste Sensor (12a) eine erste Antenne aufweist, die dafür eingerichtet ist, Funkfrequenzsignale (26) mit der Lichtbogenfunkfrequenzkennlinie zu detektieren.

10. System (10) nach einem der vorstehenden Ansprüche, wobei der zweite Sensor (12b) eine zweite Antenne aufweist, die dafür eingerichtet ist, Funkfrequenzsignale (26) mit der Störungsfunkfrequenzkennlinie zu detektieren.

## Revendications

1. Système (10), destiné à identifier un amorçage (58) d'arc dans un équipement (28) de distribution électrique, comprenant
un premier capteur (12a), disposé à proximité de l'équipement (28) de distribution électrique, destiné à capter un premier signal radiofréquence (26), susceptible de comporter une caractéristique de radiofréquence d'amorçage d'arc, indicatrice d'un amorçage (58) d'arc, produit dans l'équipement (28) de distribution électrique et
un second capteur (12b), disposé à proximité de l'équipement (28) de distribution électrique, destiné à capter un second signal radiofréquence (27), susceptible de comporter une caractéristique de radiofréquence de bruit, indicatrice d'un bruit électrique de fond, produit par l'équipement (28) de distribution électrique ;
un processeur (20) de signaux, destiné à traiter la premier signal radiofréquence (26) et le second signal radiofréquence (27), détectés par les capteurs (12a et 12b) respectifs, pour extraire la caractéristique de radiofréquence d'amorçage d'arc et la caractéristique de radiofréquence de bruit des signaux (26),
**caractérisé en ce que**
le système (10) comprend un discriminateur, destiné à discriminer la caractéristique de radiofréquence d'amorçage d'arc de la caractéristique de radiofréquence de bruit, pour identifier l'occurrence d'un amorçage (58) d'arc et
un générateur (19) d'alarme à arc, destiné à générer un signal (18) de défaut d'arc, indicateur de l'occurrence d'un amorçage (58) d'arc.

2. Système (10) selon la revendication 1, comprenant, en outre :
une mémoire (16), destinée à stocker une caractéristique de radiofréquence d'amorçage d'arc, indicatrice d'un amorçage (58) d'arc, produit dans l'équipement (28) de distribution électrique et une caractéristique de radiofréquence de bruit, indicatrice d'un bruit électrique de fond et
un processeur (14), comprenant le processeur (20) de signaux et comportant, en outre, un comparateur, destiné à comparer les caractéristiques des fréquence extraites à la caractéristique de radiofréquence d'amorçage d'arc et à la caractéristique de radiofréquence de bruit, stockées dans la mémoire (16), pour identifier l'occurrence d'un amorçage (58) d'arc.

3. Système (10) selon la revendication 1 ou la revendication 2, dans lequel la caractéristique de radiofréquence d'amorçage d'arc comprend une réponse en fréquence de crête, différente d'une réponse en fréquence de crête de la caractéristique de radiofréquence de bruit.

4. Système (10) selon l'une quelconque des revendications précédentes, dans lequel la caractéristique de radiofréquence d'amorçage d'arc comprend une amplitude de réponse en fréquence de crête, différente d'une amplitude de réponse en fréquence de crête de la caractéristique de radiofréquence de bruit.

5. Système (10) selon l'une quelconque des revendications précédentes, dans lequel la caractéristique de radiofréquence d'amorçage d'arc est identifiée suivant un niveau de courant, présent dans l'équipement électrique.

6. Système (10) selon l'une quelconque des revendications précédentes, dans lequel la caractéristique de radiofréquence d'amorçage d'arc comprend une réponse en fréquence de crête d'environ 10 mégahertz à environ 50 mégahertz, pour un courant, inférieur à environ 1 kilo-volt-ampère.

7. Système (10) selon l'une quelconque des revendications précédentes, dans lequel la caractéristique de radiofréquence d'amorçage d'arc comprend une réponse en fréquence de crête d'environ 1 mégahertz à environ 5 mégahertz, pour un courant, supérieur à environ 1 kilo-volt-ampère.

8. Système (10) selon l'une quelconque des revendications précédentes, dans lequel la caractéristique de radiofréquence d'amorçage d'arc comprend une amplitude de réponse en fréquence de crête, supérieure à une amplitude de réponse en fréquence de bruit, sensible à une distance du premier capteur (12a) par rapport à une source de l'amorçage (58) d'arc.

9. Système (10) selon l'une quelconque des revendications précédentes, dans lequel le premier capteur (12a) comprend une première antenne, configurée pour détecter des signaux radiofréquence (26), ayant la caractéristique de radiofréquence d'amorçage d'arc.

10. Système (10) selon l'une quelconque des revendications précédentes, dans lequel le second capteur (12b) comprend une seconde antenne, configurée pour détecter les signaux radiofréquence (26), ayant la caractéristique de radiofréquence de bruit.
